# EUROPEAN PATENT APPLICATION

(11) **EP 4 733 774 A1**
(43) Date of publication of application: **29.04.2026**
(21) Application number: 24835085.2
(22) Date of filing: 27.03.2024
(51) Int. Cl.: G01R 1/04

(54) **ELECTRICALLY CONDUCTIVE BLOCK AND TESTING MECHANISM**

(30) Priority: 04.07.2023 CN 202310813013
(71) Applicant: Contemporary Amperex Technology Co., Limited, Ningde, Fujian 352100 (CN)
(72) Inventor: JIANG, Fan, Ningde, Fujian 352100 (CN); HE, Qingqing, Ningde, Fujian 352100 (CN); AI, Yuquan, Ningde, Fujian 352100 (CN)
(74) Representative: Gong, Jinping
(86) International application number: PCT/CN2024/084025
(87) International publication number: WO 2025/007598

(57) **Abstract**

A conductive block and a detection mechanism are provided. The conductive block (1) is used for pressing electrode tabs (102) of an electrode assembly (100) for withstand voltage testing, where the conductive block (1) includes a transition surface (3), and the transition surface (3) matches an inclined surface formed after the electrode tabs (102) are pressed. Withstand voltage testing on the electrode assembly (100) through the conductive block (1) is conducted, where the transition surface (3) matches the inclined surface formed after the electrode tabs (102) are pressed, reducing the risk of stress concentration causing damage to the electrode tabs (102) due to the conductive block (1) abutting the electrode tabs (102) during pressing, as well as the risk of stress concentration causing damage to the electrode tabs (102) due to the conductive block (1) abutting the electrode tabs (102), and also reducing the risk of creases generated during pressing causing the electrode tabs (102) to lift, thereby improving the reliability of the electrode assembly (100), and thus improving the reliability of battery cells (105) and batteries (110).

## Description

### CROSS-REFERENCE TO RELATED APPLICATIONS

This application claims priority to Chinese Patent Application No. 202310813013.X, filed on July 4, 2023 and entitled "CONDUCTIVE BLOCK AND DETECTION MECHANISM," which is incorporated herein by reference in its entirety.

### TECHNICAL FIELD

The present application relates to the field of battery production technology, and more particularly, to a conductive block and a detection mechanism.

### BACKGROUND

Energy conservation and emission reduction are key to the sustainable development of the automotive industry, and electric vehicles, due to their advantages in energy efficiency and environmental friendliness, have become an important component of the sustainable development of the automotive industry. For electric vehicles, battery technology is an important factor in connection with their development.

In the development of battery technology, how to improve the reliability of batteries is a technical problem that urgently needs to be addressed in battery technology.

### SUMMARY

The present application provides a conductive block and a detection mechanism capable of improving the reliability of batteries.

The present application is implemented through the following technical solutions:

According to a first aspect, the present application provides a conductive block used for pressing electrode tabs of an electrode assembly for withstand voltage testing, where the conductive block includes a transition surface, and the transition surface matches an inclined surface formed after the electrode tabs are pressed.

The technical solution of the embodiments of the present application conducts withstand voltage testing on the electrode assembly through the conductive block, where the transition surface matches the inclined surface formed after the electrode tabs are pressed, reducing the risk of stress concentration causing damage to the electrode tabs due to the conductive block abutting the electrode tabs during pressing, as well as the risk of stress concentration causing damage to the electrode tabs due to the conductive block abutting the electrode tabs, and also reducing the risk of creases generated during pressing causing the electrode tabs to lift, thereby improving the reliability of the electrode assembly, and thus improving the reliability of battery cells and batteries.

In some embodiments, the conductive block further includes a first surface, the first surface is used for pressing the electrode tabs, and the transition surface is disposed adjacent to the first surface.

In some embodiments, the first surface and the transition surface are both planar, and an angle formed between the first surface and the transition surface is an obtuse angle.

The technical solution of the embodiments of the present application conducts withstand voltage testing on the electrode assembly through the conductive block, where the first surface of the conductive block presses the electrode tabs of the electrode assembly, and when both the transition surface and the first surface are planar, an included angle between the transition surface and the first surface is an obtuse angle. When the first surface presses the electrode tabs, the included angle between the transition surface and the first surface being an obtuse angle reduces the risk of stress concentration causing damage to the electrode tabs due to an excessively small corresponding angle when the conductive block abuts the electrode tabs, and also reduces the risk of creases generated during pressing causing the electrode tabs to lift, thereby improving the reliability of the electrode assembly, and thus improving the reliability of battery cells and batteries.

In some embodiments, the angle between the first surface and the transition surface is α1, satisfying: 110° ≤ α1 ≤ 150°.

In the technical solution of the embodiments of the present application, the first surface and the transition surface are both planar, and the angle α1 between the first surface and the transition surface satisfies 110° ≤ α1 ≤ 150°. When α1 ≥ 110°, it reduces the risk of stress concentration causing damage to the electrode tabs due to an excessively small angle corresponding to a first edge where the conductive block abuts the electrode tabs, and also reduces the risk of creases generated during pressing causing the electrode tabs to lift, thereby improving the reliability of the electrode assembly, and thus improving the reliability of battery cells and batteries. When α1 ≤ 150°, it reduces the risk of stress concentration causing damage to the electrode tabs due to an excessively small angle corresponding to a second edge where the conductive block abuts the electrode tabs, and also reduces the risk of creases generated during pressing causing the electrode tabs to lift, thereby improving the reliability of the electrode assembly, and thus improving the reliability of battery cells and batteries.

In some embodiments, the first surface is planar, and the transition surface is an arcuate surface.

In some embodiments, the transition surface is tangent to the first surface.

In the technical solution of the embodiments of the present application, when the first surface is planar and the transition surface is an arcuate surface, the transition surface is tangent to the first surface, making the abutment of the first surface with the electrode tabs smoother when the conductive block presses the electrode tabs, reducing the risk of damage to the electrode tabs due to the first surface abutting the electrode tabs, and also reducing the risk of creases generated during pressing causing the electrode tabs to lift, thereby improving the reliability of the electrode assembly, and thus improving the reliability of battery cells and batteries.

In some embodiments, the conductive block further includes a second surface, the first surface, the transition surface, and the second surface are sequentially disposed along a circumferential direction of the conductive block, the first surface intersects the transition surface at a first edge, and the transition surface connects to and intersects the second surface at a second edge; where the first edge and the second edge define a first reference plane, and the transition surface is an arcuate surface protruding from the first reference plane.

The technical solution of the embodiments of the present application conducts withstand voltage testing on the electrode assembly through the conductive block, where the first surface of the conductive block presses the electrode tabs of the electrode assembly, the first surface is connected to the transition surface via the first edge, and the second surface is connected to the transition surface via the second edge. When the first surface presses the electrode tabs, both the first edge and the second edge can abut the electrode tabs, reducing the risk of stress concentration causing damage to the electrode tabs due to only one edge abutting the electrode tabs during pressing by the conductive block, and also reducing the risk of creases generated during pressing causing the electrode tabs to lift, thereby improving the reliability of the electrode assembly, and thus improving the reliability of battery cells and batteries.

In some embodiments, an angle formed between the first reference plane and the first surface is an obtuse angle.

In the technical solution of the embodiments of the present application, when the transition surface is an arcuate surface, the included angle between the first reference plane defined by the first edge and the second edge and the first surface is an obtuse angle. When the first surface presses the electrode tabs, both the first edge and the second edge can abut the electrode tabs, and the included angle between the first reference plane and the first surface being an obtuse angle reduces the risk of stress concentration causing damage to the electrode tabs due to only one edge abutting the electrode tabs during pressing by the conductive block, as well as the risk of stress concentration causing damage to the electrode tabs due to an excessively small angle corresponding to the first edge where the conductive block abuts the electrode tabs, and also reduces the risk of creases generated during pressing causing the electrode tabs to lift, thereby improving the reliability of the electrode assembly, and thus improving the reliability of battery cells and batteries.

In some embodiments, an angle between the first reference plane and the first surface is α2, satisfying: 110° ≤ α2 ≤ 150°.

In the technical solution of the embodiments of the present application, the first surface is planar, the transition surface is an arcuate surface, and the angle α2 between the first surface and the first reference plane satisfies 110° ≤ α2 ≤ 150°. When α2 ≥ 110°, it reduces the risk of stress concentration causing damage to the electrode tabs due to an excessively small angle corresponding to the first edge where the conductive block abuts the electrode tabs, and also reduces the risk of creases generated during pressing causing the electrode tabs to lift, thereby improving the reliability of the electrode assembly, and thus improving the reliability of battery cells and batteries. When α2 ≤ 150°, it reduces the risk of stress concentration causing damage to the electrode tabs due to an excessively small angle corresponding to the second edge where the conductive block abuts the electrode tabs, and also reduces the risk of creases generated during pressing causing the electrode tabs to lift, thereby improving the reliability of the electrode assembly, and thus improving the reliability of battery cells and batteries.

In some embodiments, the transition surface is tangent to the second surface.

In the technical solution of the embodiments of the present application, when the second surface is planar and the transition surface is an arcuate surface, the transition surface is tangent to the second surface, making the abutment of the second edge with the electrode tabs smoother when the conductive block presses the electrode tabs, reducing the risk of damage to the electrode tabs due to the second edge of the conductive block abutting the electrode tabs, and also reducing the risk of creases generated during pressing causing the electrode tabs to lift, thereby improving the reliability of the electrode assembly, and thus improving the reliability of battery cells and batteries.

In some embodiments, an extension plane of the first surface intersects an extension plane of the second surface.

In some embodiments, the extension plane of the first surface is orthogonal to the extension plane of the second surface.

In some embodiments, the first surface is planar, the transition surface is an arcuate surface, a second reference plane is parallel to the first reference plane, and the second reference plane is tangent to the transition surface, a distance between the first reference plane and the second reference plane is d1, the extension plane of the first surface intersects the extension plane of the second surface at a first reference line, the first reference line is parallel to the first reference plane, and a distance between the first reference line and the first reference plane is d2, satisfying: 0.3d2 ≤ d1 ≤ 0.7d2.

In the technical solution of the embodiments of the present application, a distance between the first reference plane and the second reference plane is d1, and a distance between the first reference line and the first reference plane is d2, satisfying 0.3d2 ≤ d1 ≤ 0.7d2. When d1 ≥ 0.3d2, it can increase a contact area between the transition surface and the electrode tabs, reducing the risk of damage to the electrode tabs due to the second edge of the conductive block abutting the electrode tabs, and also reducing the risk of creases generated during pressing causing the electrode tabs to lift, thereby improving the reliability of the electrode assembly, and thus improving the reliability of battery cells and batteries. When d1 ≤ 0.7d2, it can reduce the risk of damage to the electrode tabs due to excessive protrusion of the transition surface beyond the first reference plane, and also reduce the risk of stress concentration causing damage to the electrode tabs due to the second edge not abutting the electrode tabs, leading to the first edge abutting the electrode tabs.

In some embodiments, the conductive block includes a third surface connected to the second surface, the third surface is parallel to the first surface, and a distance between the first surface and the third surface is d3, satisfying: 0 < d3 ≤ 50 mm.

In the technical solution of the embodiments of the present application, the third surface is connected to the second surface and the third surface is parallel to the second surface, and a distance d3 between the first surface and the third surface satisfies 0 < d3 ≤ 50 mm. During withstand voltage testing of the electrode assembly, after clamping both ends of the main body of the electrode assembly with pressing plates, the conductive block presses the electrode tabs, and when d3 ≤ 50 mm, the risk of interference between the conductive block and the pressing plates due to an excessively large size of the conductive block can be reduced, thereby improving the convenience of pressing the electrode tabs with the conductive block.

In some embodiments, 10 mm ≤ d3 ≤ 20 mm.

In the technical solution of the embodiments of the present application, a distance d3 between the first surface and the third surface satisfies 10 mm ≤ d3 ≤ 20 mm. When d3 ≥ 10 mm, the conductive block has a certain thickness, facilitating the pressing of the electrode tabs and improving operational convenience. When d3 ≤ 20 mm, the risk of interference between the conductive block and the pressing plates due to an excessively large size of the conductive block can be better reduced, thereby improving the convenience of pressing the electrode tabs with the conductive block.

In some embodiments, the first surface is parallel to the second surface, and a distance between the first surface and the second surface is d4, satisfying: 0 < d4 ≤ 50 mm.

In the technical solution of the embodiments of the present application, the first surface is parallel to the second surface, and a distance d4 between the first surface and the second surface satisfies 0 < d4 ≤ 50 mm. During withstand voltage testing of the electrode assembly, after clamping both ends of the main body of the electrode assembly with pressing plates, the conductive block presses the electrode tabs, and when d4 ≤ 50 mm, the risk of interference between the conductive block and the pressing plates due to an excessively large size of the conductive block can be reduced, thereby improving the convenience of pressing the electrode tabs with the conductive block.

In some embodiments, 10 mm ≤ d4 ≤ 20 mm.

In the technical solution of the embodiments of the present application, a distance d4 between the first surface and the second surface satisfies 10 mm ≤ d4 ≤ 20 mm. When d4 ≥ 10 mm, the conductive block has a certain thickness, facilitating the pressing of the electrode tabs and improving operational convenience. When d4 ≤ 20 mm, the risk of interference between the conductive block and the pressing plates due to an excessively large size of the conductive block can be better reduced, thereby improving the convenience of pressing the electrode tabs with the conductive block.

According to a second aspect, the present application further provides a detection mechanism used for withstand voltage testing of an electrode assembly, where the detection mechanism includes a conductive block according to any one of the embodiments of the first aspect, a first pressing plate, a second pressing plate, and an elastic member, where the conductive block is used for pressing electrode tabs of the electrode assembly, the first pressing plate and the second pressing plate are spaced apart along a first direction, the first pressing plate and the second pressing plate are used for clamping a main body of the electrode assembly; one end of the elastic member is connected to the first pressing plate, and another end of the elastic member is connected to the conductive block.

In the technical solution of the embodiments of the present application, the detection mechanism conducts withstand voltage testing on the electrode assembly, the detection mechanism includes the first pressing plate, the second pressing plate, the conductive block, and the elastic member. The first pressing plate and the second pressing plate together clamp the main body of the electrode assembly, the conductive block is connected to the first pressing plate via the elastic member, and the conductive block presses the electrode tabs of the electrode assembly. The detection mechanism conducts withstand voltage testing on the electrode assembly, reducing the risk of damage to the electrode tabs, as well as the risk of creases generated during pressing causing the electrode tabs to lift, thereby improving the reliability of the electrode assembly, and thus improving the reliability of battery cells and batteries.

In some embodiments, the conductive block is configured as two, the two conductive blocks are respectively used for pressing a positive electrode tab and a negative electrode tab of the electrode assembly.

In the technical solution of the embodiments of the present application, the two conductive blocks respectively press the positive electrode tab and the negative electrode tab, where simultaneously pressing the positive electrode tab and the negative electrode tab improves detection efficiency and convenience.

In some embodiments, a distance between the two conductive blocks is adjustable to adapt to electrode assemblies of different sizes.

In the technical solution of the embodiments of the present application, the two conductive blocks respectively press the positive electrode tab and the negative electrode tab. For electrode assemblies of different sizes, the distance between the positive electrode tab and the negative electrode tab varies. By adjusting the distance between the two conductive blocks, it adapts to electrode assemblies of different sizes to press positive electrode tabs and negative electrode tabs at different distances, thereby improving the practicality and applicability of the detection mechanism.

In some embodiments, the first pressing plate is provided with a slide rod and a slide block, the slide block is slidably disposed on the slide rod, one end of the elastic member is connected to the slide block, and another end of the elastic member is connected to the conductive block.

In the technical solution of the embodiments of the present application, by providing the slide rod on the first pressing plate and connecting the conductive block to the slide block via the elastic member, the slide block can slide on the slide rod to achieve adjustment of the distance between the two conductive blocks, improving the applicability and practicality of the detection mechanism. Additionally, the slide rod and slide block structure is simple, easy to obtain, and cost-effective.

Additional aspects and advantages of the present application will be partially provided in the following description, partially become apparent from the following description, or be understood through the practice of the present application.

### BRIEF DESCRIPTION OF DRAWINGS

To more clearly illustrate the technical solutions of the embodiments of the present application, the drawings required for use in the embodiments will be briefly introduced below. It should be understood that the following drawings only show certain embodiments of the present application and therefore should not be regarded as limiting the scope. For those of ordinary skill in the art, other related drawings can be obtained based on these drawings without creative efforts.
FIG. 1 is a schematic structural diagram of a vehicle according to some embodiments of the present application;
FIG. 2 is a schematic structural diagram of a battery according to some embodiments of the present application;
FIG. 3 is a schematic structural diagram of a battery cell according to some embodiments of the present application;
FIG. 4 is a schematic structural diagram of a conductive block provided by some embodiments of the present application;
FIG. 5 is a schematic diagram of the conductive block in FIG. 4 from another perspective;
FIG. 6 is a schematic structural diagram of a conductive block provided by some other embodiments of the present application;
FIG. 7 is a schematic diagram of the conductive block in FIG. 6 from another perspective;
FIG. 8 is a schematic diagram of a conductive block provided by yet some other embodiments of the present application;
FIG. 9 is a schematic diagram of a conductive block provided by still some other embodiments of the present application;
FIG. 10 is a schematic structural diagram of a detection mechanism provided by some embodiments of the present application; and
FIG. 11 is a schematic diagram of the detection mechanism in FIG. 10 from another perspective.

Reference signs:
1 - conductive block; 2 - first surface; 3 - transition surface; 4 - second surface; 5 - first edge; 6 - second edge; 7 - first reference plane; 8 - second reference plane; 9 - third surface; 10 - detection mechanism; 11 - first pressing plate; 12 - second pressing plate; 13 - elastic member; 14 - slide rod; 15 - slide block; 16 - fourth surface; 17 - fifth surface; 18 - first reference line; 19 - sub-surface; 100 - electrode assembly; 101 - main body; 102 - electrode tab; 103 - positive electrode tab; 104 - negative electrode tab; 105 - battery cell; 106 - housing; 107 - electrode terminal; 108 - shell; 109 - end cover; 110 - battery; 111 - battery box; 112 - first sub-box; 113 - second sub-box; 1000 - vehicle; 1100 - controller; 1200 - motor; X - first direction; Y - second direction; and Z - third direction.

### DESCRIPTION OF EMBODIMENTS

To make the objectives, technical solutions, and advantages of the embodiments of the present application clearer, the technical solutions in the embodiments of the present application will be described clearly and completely below in conjunction with the drawings in the embodiments of the present application. Obviously, the described embodiments are some, but not all, embodiments of the present application. All other embodiments obtained by those of ordinary skill in the art based on the embodiments of the present application without creative efforts shall fall within the protection scope of the present application.

Unless otherwise defined, all technical and scientific terms used in the present application have the same meanings as commonly understood by those skilled in the technical field of the present application; the terms used in the specification of the present application are for the purpose of describing specific embodiments only and are not intended to limit the present application; the terms "include" and "have" and any variations thereof in the specification, claims, and the above description of the drawings of the present application are intended to cover non-exclusive inclusion. In the specification, claims, or accompanying drawings of the present application, the terms "first," "second," and the like are intended to distinguish between different objects rather than to indicate a particular order or relative importance.

Reference to "embodiment" in the present application means that specific features, structures, or characteristics described with reference to the embodiment may be included in at least one embodiment of the present application. The appearance of the phrase in various positions in the specification does not necessarily refer to the same embodiment, nor is it an independent or alternative embodiment mutually exclusive with other embodiments. It is explicitly or implicitly understood by those skilled in the art that the embodiments described in the present application may be combined with other embodiments.

In the description of the present application, it should be noted that unless otherwise specified and defined explicitly, the terms "mounting," "connection," "join," and "attachment" should be understood in their general senses. For example, they may refer to a fixed connection, a detachable connection, or an integral connection, and may refer to a direct connection, an indirect connection via an intermediate medium, or an internal communication between two elements. For those of ordinary skill in the art, the specific meanings of the above terms in the present application can be understood based on specific circumstances.

The term "and/or" in the present application is merely an association relationship describing associated objects, indicating that three relationships may exist. For example, A and/or B may indicate: A exists alone, A and B exist simultaneously, and B exists alone. In addition, the character "/" in the present application generally indicates an "or" relationship between the contextually associated objects.

In the present application, "a plurality of" means more than two (inclusive). Similarly, "a plurality of groups" means more than two (inclusive) groups, and "a plurality of pieces" means more than two (inclusive) pieces.

In some embodiments, the battery may be a battery module, and when there are a plurality of battery cells, the plurality of battery cells are arranged and fastened to form a battery module.

In some embodiments, the battery may be a battery pack, the battery pack includes a box and battery cells, and the battery cells or battery modules are accommodated in the box.

In some embodiments, the box may be used as part of the chassis structure of a vehicle. For example, part of the box may become at least part of the chassis of a vehicle, or part of the box may become at least parts of a cross beam and longitudinal beam of a vehicle.

In some embodiments, the battery may be an energy storage apparatus. The energy storage apparatus includes an energy storage container, an energy storage electric cabinet, and the like.

In the embodiments of the present application, the battery cell may be a secondary battery, and the secondary battery refers to a battery cell that can be recharged to activate active materials for continuous use after the battery cell is discharged.

The battery cell may be, but is not limited to, a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, and a lead storage battery.

In an example, the battery cell may be a cylindrical battery cell, a prismatic battery cell, a pouch battery cell, or a battery cell of another shape. The prismatic battery cell includes a square shell battery cell, a blade battery cell, and a polygonal battery, such as a hexagonal battery. This is not particularly limited in the embodiments of the present application.

The battery cell typically includes an electrode assembly. The electrode assembly includes a positive electrode, a negative electrode, and a separator. During charging and discharging process of the battery cell, active ions (such as lithium ions) intercalate and deintercalate back and forth between the positive electrode and the negative electrode. The separator is arranged between the positive electrode and the negative electrode to prevent short circuit of the positive electrode and the negative electrode and to allow the active ions to pass through.

In some embodiments, the positive electrode may be a positive electrode plate, and the positive electrode plate may include a positive electrode current collector and a positive electrode active material disposed on at least one surface of the positive electrode current collector.

In an example, the positive electrode current collector includes two back-to-back surfaces in a thickness direction of the positive electrode current collector, and the positive electrode active material is disposed on either or both of the two back-to-back surfaces of the positive electrode current collector.

In an example, the positive electrode current collector may be a metal foil current collector or a composite current collector. For example, as the metal foil, the positive electrode current collector may use aluminum with a silver-plated surface, stainless steel with a silver-plated surface, stainless steel, copper, aluminum, nickel, baked carbon, carbon, nickel, or titanium. The composite current collector may include a polymer material matrix and a metal layer. The composite current collector may be formed by forming a metal material (aluminum, aluminum alloy, nickel, nickel alloy, titanium, titanium alloy, silver, silver alloy, or the like) on a polymer material matrix (for example, a matrix of polypropylene, polyethylene terephthalate, polybutylene terephthalate, polystyrene, or polyethylene).

In an example, the positive electrode active material may include at least one of the following materials: lithium-containing phosphate, lithium transition metal oxide, and respective modified compounds thereof. However, the present application is not limited to such materials, and may alternatively use other conventional well-known materials that can be used as positive electrode active materials for batteries.

In some embodiments, the negative electrode may be a negative electrode plate, and the negative electrode plate may include a negative electrode current collector.

In an example, the negative electrode current collector may be a metal foil current collector or a composite current collector. For example, as the metal foil, the negative electrode current collector may use aluminum with a silver-plated surface, stainless steel with a silver-plated surface, stainless steel, copper, aluminum, nickel, baked carbon, carbon, nickel, or titanium.

In some embodiments, the negative electrode current collector includes two back-to-back surfaces in its thickness direction, and the negative electrode active material is disposed on either or both of the two back-to-back surfaces of the negative electrode current collector.

In an example, the negative electrode active material may be a negative electrode active material for batteries well-known in the art. In an example, the negative electrode active material may include at least one of the following materials: artificial graphite, natural graphite, soft carbon, hard carbon, a silicon-based material, a tin-based material, lithium titanate, or the like. The silicon-based material may be selected from at least one of elemental silicon, silicon-oxygen compound, silicon-carbon composite, silicon-nitrogen composite, or silicon alloy. The tin-based material may be selected from at least one of elemental tin, tin-oxygen compound, or tin alloy. However, the present application is not limited to these materials, and other conventional materials that can be used as negative electrode active materials for batteries may also be used. These negative electrode active materials may be used alone or in combination of two or more.

In some embodiments, the separator is a diaphragm. The present application has no particular restriction on the type of diaphragm, and any well-known porous structure diaphragm with good chemical stability and mechanical stability can be selected.

As an example, the main material of the diaphragm may be selected from at least one of glass fiber, nonwoven fabric, polyethylene, polypropylene, polyvinylidene fluoride, and ceramic. The diaphragm may be a single-layer film or a multi-layer composite film, and is not particularly limited. When the diaphragm is a multi-layer composite film, all layers may be made of the same or different materials, which is not particularly limited. The separator may be an independent component located between the positive electrode and the negative electrode, or may be attached to surfaces of the positive electrode and the negative electrode.

In some embodiments, the separator is a solid electrolyte. The solid electrolyte is arranged between the positive electrode and the negative electrode, and plays the roles of transporting ions and isolating the positive electrode and the negative electrode.

In some embodiments, the electrode assembly is a wound structure. The positive electrode plate and the negative electrode plate are wound into a wound structure.

Currently, from the perspective of market development, batteries have been widely used in electric vehicles such as electric bicycles, electric motorcycles, and electric cars, as well as electric tools, drones, energy storage devices, and other fields. With the continuous expansion of battery applications, the market demand for batteries is also continuously increasing.

The development of battery technology needs to consider multiple design factors simultaneously, such as energy density, cycle life, discharge capacity, charge-discharge rate, and other performance parameters. Additionally, with changes in environmental conditions and/or internal conditions of the battery, the reliability of the battery is also one of the key factors to consider.

Currently, for produced electrode assemblies, withstand voltage testing, that is, short-circuit testing, is typically performed before use. The testing method involves pressing the electrode tabs with a conductive block to establish electrical connection with the electrode tabs, and electrically connecting an external withstand voltage testing mechanism to the conductive block to perform withstand voltage testing of the electrode assembly.

However, during the process of pressing the electrode tabs of the electrode assembly with the conductive block, when the conductive block presses the electrode tabs with its peripheral surface, the electrode tabs may have multiple layers, and the thickness of the multi-layer electrode tabs may be significant. With existing conductive blocks, creases generated during pressing may cause the electrode tabs to lift, leading to risks such as poor welding, such as missed welds, when the electrode tabs of the electrode assembly are welded to a connecting piece or a top cover during the formation of a battery cell, or excessive stress concentration in the creased portion may damage the electrode tabs, thereby affecting the reliability of the battery cell, and further affecting the reliability of the battery.

Based on the above considerations, to reduce the risk of stress concentration causing damage to the electrode tabs due to the conductive block abutting the electrode tabs, and to reduce the risk of creases generated during pressing causing the electrode tabs to lift, which may lead to poor welding such as missed welds, thereby improving the reliability of the electrode assembly and the reliability of the battery, embodiments of the present application provide a conductive block used for pressing electrode tabs of an electrode assembly for withstand voltage testing, where the conductive block includes a transition surface, and the transition surface matches an inclined surface formed after the electrode tabs are pressed.

By conducting withstand voltage testing on the electrode assembly through the conductive block, the transition surface matches the inclined surface formed after the electrode tabs are pressed, reducing the risk of stress concentration causing damage to the electrode tabs due to the conductive block abutting the electrode tabs during pressing, as well as the risk of stress concentration causing damage to the electrode tabs due to the conductive block abutting the electrode tabs, and also reducing the risk of creases generated during pressing causing the electrode tabs to lift, thereby improving the reliability of the electrode assembly, and thus improving the reliability of battery cells and batteries.

The battery disclosed in the embodiments of the present application may be used without limitation in electric devices such as vehicles, ships, or aircraft. A power supply system for such electric devices can be composed using the battery disclosed in the present application.

An embodiment of the present application provides an electric device that uses a battery as a power source. The electric device may be, but is not limited to, a mobile phone, a tablet computer, a laptop computer, an electric toy, an electric tool, an electric bicycle, an electric motorcycle, an electric car, a ship, or a spacecraft. The electric toy may be a fixed or mobile electric toy, for example, a game console, an electric toy car, an electric toy ship, or an electric toy airplane. The spacecraft may include an airplane, a rocket, a space shuttle, a spaceship, or the like.

The following embodiments, for convenience of explanation, take an electric device as a vehicle 1000 as an example for description in some embodiments of the present application.

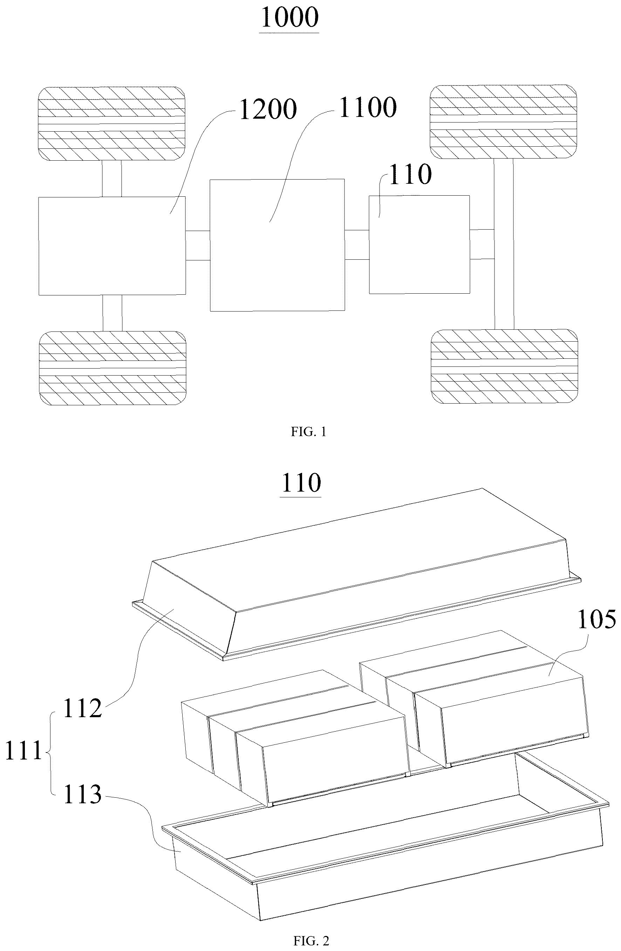

Referring to FIG. 1, FIG. 1 is a schematic structural diagram of a vehicle 1000 provided by some embodiments of the present application. The vehicle 1000 may be a fuel vehicle, a gas vehicle, or a new energy vehicle, and the new energy vehicle may be a pure electric vehicle, a hybrid vehicle, or an extended-range vehicle. The vehicle 1000 is provided with a battery 110 inside, and the battery 110 may be disposed at the bottom, front, or rear of the vehicle 1000. The battery 110 may be used for supplying power to the vehicle 1000. For example, the battery 110 may be used as an operational power source for the vehicle 1000 for use in a circuit system of the vehicle 1000, for example, to satisfy power needs of start, navigation, and running of the vehicle 1000.

The vehicle 1000 may further include a controller 1100 and a motor 1200, where the controller 1100 is used for controlling the battery 110 to supply power to the motor 1200, for example, to satisfy power needs of start, navigation, and driving of the vehicle 1000.

In some embodiments of the present application, the battery 110 can be used not only as the operational power source for the vehicle 1000 but also as a driving power source for the vehicle 1000, replacing or partially replacing fossil fuel or natural gas to provide driving traction for the vehicle 1000.

Referring to FIG. 2, FIG. 2 is an exploded view of a battery 110 provided by some embodiments of the present application. The battery 110 may further include a battery box 111, and battery cells 105 are accommodated in the battery box 111. The battery box 111 is used for providing an accommodating space for the battery cells 105, and the battery box 111 may have various structures. In some embodiments, the battery box 111 may include a first sub-box 112 and a second sub-box 113, the first sub-box 112 and the second sub-box 113 cover each other, and the first sub-box 112 and the second sub-box 113 together define an accommodating space for accommodating the battery cells 105. The second sub-box 113 may be a hollow structure with an open end, the first sub-box 112 may be a platelike structure, and the first sub-box 112 covers the open side of the second sub-box 113, so that the first sub-box 112 and the second sub-box 113 together define the accommodating space; alternatively, the first sub-box 112 and the second sub-box 113 may both be hollow structures with an open side, and the open side of the first sub-box 112 covers the open side of the second sub-box 113.

In the battery 110, there may be a plurality of battery cells 105, and the plurality of battery cells 105 may be connected in series, parallel, or series-parallel, where series-parallel refers to a combination of series and parallel connections among the plurality of battery cells 105. The plurality of battery cells 105 may be directly connected in series, parallel, or series-parallel, and then an entirety of the plurality of battery cells 105 is accommodated in the battery box 111. Alternatively, the plurality of battery cells 105 may first be connected in series, parallel, or series-parallel to form a battery module, and then a plurality of such battery modules are connected in series, parallel, or series-parallel to form an entirety, which is accommodated in the battery box 111 to form the battery 110. The battery 110 may further include other structures, for example, the battery 110 may further include a busbar component for achieving electrical connection between the plurality of battery cells 105.

The battery cell 105 may be a secondary battery or a primary battery; the battery cell 105 may also be a lithium-sulfur battery, a sodium-ion battery, or a magnesium-ion battery, but is not limited thereto.

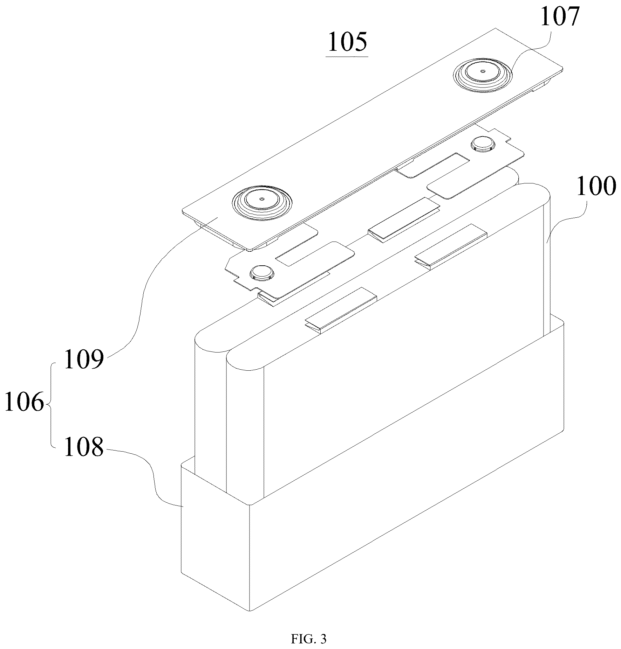

Referring to FIG. 3, FIG. 3 is an exploded view of a battery cell 105 provided by some embodiments of the present application. As shown in FIG. 3, the battery cell 105 includes a housing 106, an electrode assembly 100, and an electrode terminal 107. The housing 106 includes a shell 108 and an end cover 109, where the shell 108 has an opening, and the end cover 109 closes the opening to separate the internal environment of the battery cell 105 from the external environment.

The shell 108 is an assembly used for cooperating with the end cover 109 to form an internal environment of the battery cell 105, where the formed internal environment can be used to accommodate the electrode assembly 100, an electrolyte, and other components. The shell 108 and the end cover 109 may be independent components. The shell 108 may be of various shapes and sizes. Specifically, a shape of the shell 108 may be determined according to a specific shape and size of the electrode assembly 100. The material of the shell 108 may be various, such as copper, iron, aluminum, stainless steel, aluminum alloy, plastic, or the like.

The end cover 109 is a component that covers the opening of the shell 108 to isolate the internal environment of the battery cell 105 from the external environment. A shape of the end cover 109 is not limited and may be adapted to a shape of the shell 108 to fit the shell 108. Optionally, the end cover 109 may be made of a material (for example, aluminum alloy) with specified hardness and strength, such that the end cover 109 is less likely to deform under extrusion and collision, allowing the battery cell 105 to have a higher structural strength and improved reliability. The end cover 109 may be provided with functional components such as an electrode terminal 107. The electrode terminal 107 may be used for electrically connecting to the electrode assembly 100 for outputting or inputting electric energy of the battery cell 105. The material of the end cover 109 may also be various, such as copper, iron, aluminum, stainless steel, aluminum alloy, plastic, or the like, which is not particularly limited in the embodiments of the present application. In some embodiments, an insulating structure may also be provided inside the end cover 109, and the insulating structure may be used for isolating an electrical connection component in the shell 108 from the end cover 109 to reduce the risk of short circuit. Illustratively, the insulating structure may be plastic, rubber, or the like.

The electrode assembly 100 is a component in which electrochemical reactions take place in the battery cell 105. The shell 108 may include one or more electrode assemblies 100. The electrode assembly 100 is mainly formed by winding or stacking a positive electrode plate and a negative electrode plate, and a separating film is typically provided between the positive electrode plate and the negative electrode plate, where the separating film is used for separating the positive electrode plate and the negative electrode plate to avoid, to a certain extent, internal short circuits between the positive electrode plate and the negative electrode plate. A portion of the positive electrode plate and the negative electrode plate with active material constitutes a main body 101 of the electrode assembly 100, a portion of the positive electrode plate without active material constitutes a positive electrode tab 103, and a portion of the negative electrode plate without active material constitutes a negative electrode tab 104. The positive electrode tab 103 and the negative electrode tab 104 may be located together at one end of the main body 101. During the charging and discharging process of the battery, the positive electrode active material and the negative electrode active material react with the electrolyte, and the electrode tabs 102 connect to the electrode terminal 107 to form a current loop.

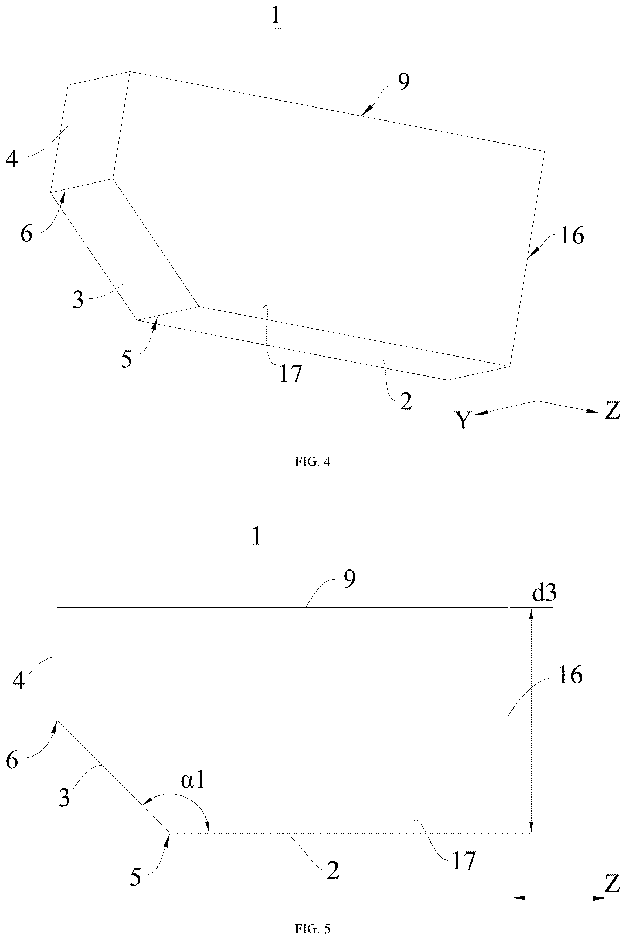

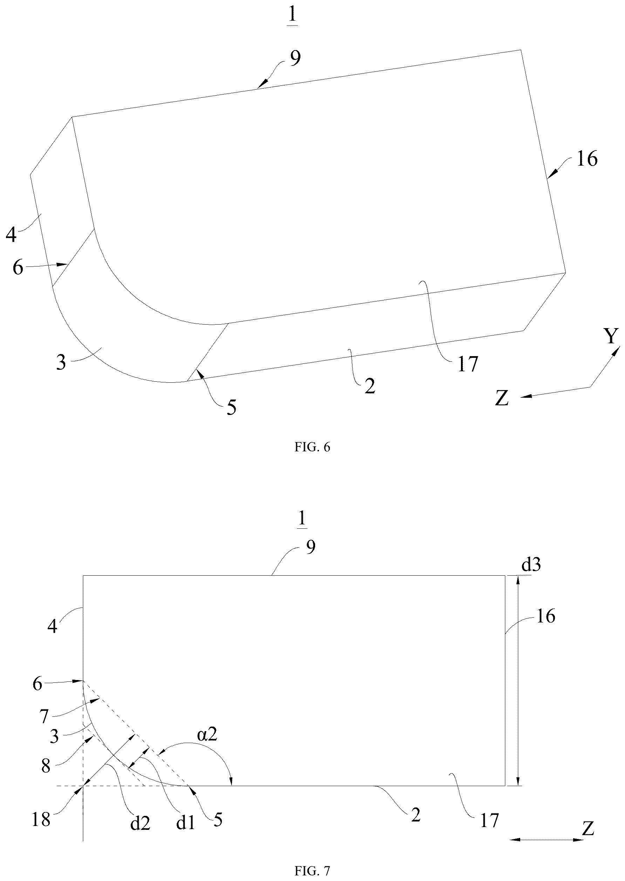

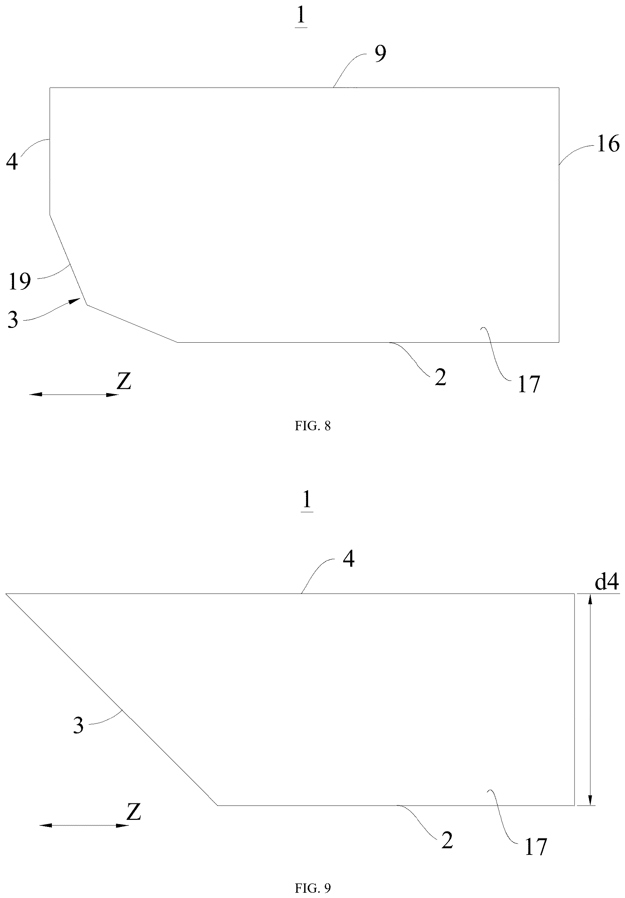

Referring to FIGs. 4 to 9, FIG. 4 is a schematic structural diagram of a conductive block 1 provided by some embodiments of the present application, FIG. 5 is a schematic diagram of the conductive block 1 in FIG. 4 from another perspective, FIG. 6 is a schematic structural diagram of a conductive block 1 provided by other embodiments of the present application, FIG. 7 is a schematic diagram of the conductive block 1 in FIG. 6 from another perspective, FIG. 8 is a schematic diagram of a conductive block 1 provided by yet some other embodiments of the present application, and FIG. 9 is a schematic diagram of a conductive block 1 provided by still some other embodiments of the present application. It should be noted that the perspectives in FIGs. 5, 7 to 9 are from a viewpoint along the second direction Y. The second direction Y may be a direction perpendicular to the fifth surface 17. Embodiments of the present application provide a conductive block 1 used for pressing electrode tabs 102 of an electrode assembly 100 for withstand voltage testing, where the conductive block 1 includes a transition surface 3, and the transition surface 3 matches an inclined surface formed after the electrode tabs 102 are pressed.

In some embodiments, the withstand voltage testing may involve pressing the electrode tabs 102 with the conductive block 1 to establish electrical connection with the electrode tabs 102, where the conductive block 1 is externally connected to a testing device to detect whether the energization of the electrode assembly 100 is qualified.

In some embodiments, the electrode tabs 102 may be multi-layer electrode tabs 102. The multi-layer electrode tabs 102 may be placed along a horizontal direction, a thickness direction of the multi-layer electrode tabs 102 may be a vertical direction, and the conductive block 1 moves downward along the vertical direction, where the first surface 2 is positioned in the horizontal direction and contacts an upper layer of the multi-layer electrode tabs 102, and presses the multi-layer electrode tabs 102 along the vertical direction, reducing a total thickness of the multi-layer electrode tabs 102. During the pressing process, the thickness of the multi-layer electrode tabs 102 decreases, a portion of the electrode tabs 102 near the main body 101 deforms, and both the first edge 5 and the second edge 6 abut the electrode tabs 102.

The technical solution of the embodiments of the present application conducts withstand voltage testing on the electrode assembly 100 through the conductive block 1, where the transition surface 3 matches the inclined surface formed after the electrode tabs 102 are pressed, reducing the risk of stress concentration causing damage to the electrode tabs 102 due to the conductive block 1 abutting the electrode tabs 102 during pressing, as well as the risk of stress concentration causing damage to the electrode tabs 102 due to the conductive block 1 abutting the electrode tabs 102, and also reducing the risk of creases generated during pressing causing the electrode tabs 102 to lift, thereby improving the reliability of the electrode assembly 100, and thus improving the reliability of battery cells 105 and batteries 110.

In some embodiments, the conductive block 1 further includes a first surface 2, the first surface 2 is used for pressing the electrode tabs 102, and the transition surface 3 is disposed adjacent to the first surface 2.

In some embodiments, the first surface 2 and the transition surface 3 are both planar, and an angle formed between the first surface 2 and the transition surface 3 is an obtuse angle.

Referring to FIGs. 4 and 5, in some embodiments, the first surface 2 and the transition surface 3 may both be planar, and an angle between a physical surface of the first surface 2 and a physical surface of the transition surface 3 is an obtuse angle, rather than an angle between extension planes. That is, during the pressing process, when the first surface 2 is disposed along the horizontal direction, the transition surface 3 is disposed inclined upward toward a direction approaching the main body 101 of the electrode assembly 100, such that both the first edge 5 and the second edge 6 abut the electrode tabs 102.

The technical solution of the embodiments of the present application conducts withstand voltage testing on the electrode assembly 100 through the conductive block 1, where the first surface 2 of the conductive block 1 presses the electrode tabs 102 of the electrode assembly 100, and when both the transition surface 3 and the first surface 2 are planar, an included angle between the transition surface 3 and the first surface 2 is an obtuse angle. When the first surface 2 presses the electrode tabs 102, the included angle between the transition surface 3 and the first surface 2 being an obtuse angle reduces the risk of stress concentration causing damage to the electrode tabs 102 due to an excessively small corresponding angle when the conductive block 1 abuts the electrode tabs 102, and also reduces the risk of creases generated during pressing causing the electrode tabs 102 to lift, thereby improving the reliability of the electrode assembly 100, and thus improving the reliability of battery cells 105 and batteries 110.

Referring to FIGs. 4 and 5, in some embodiments, the first surface 2 and the transition surface 3 are both planar, and the angle between the first surface 2 and the transition surface 3 is α1, satisfying: 110° ≤ α1 ≤ 150°.

In some embodiments, the first surface 2 and the transition surface 3 may both be planar, and an angle between the first surface 2 and the transition surface 3 is α1. During the pressing process, both the first surface 2 and the transition surface 3 extend along the second direction Y, and the first surface 2 is disposed along the horizontal direction. Taking the extension direction of the first surface 2 and the transition surface 3 as the observation direction, where the perspective direction of FIG. 5 is the same as this observation direction. In this observation direction, the first surface 2 and the transition surface 3 are two connected straight lines, and an included angle between the two straight lines is α1.

In some embodiments, α1 satisfies 110° ≤ α1 ≤ 150°. For example, α1 may be 110°, 112°, 114°, 116°, 118°, 120°, 122°, 124°, 126°, 128°, 130°, 132°, 134°, 136°, 138°, 140°, 142°, 144°, 146°, 148°, or 150°.

In some embodiments, α1 may be 135°.

In some embodiments, the method of measuring the angle α1 may involve attaching a protractor to a surface connected to both the first surface 2 and the transition surface 3 to measure the included angle α1 between the first surface 2 and the transition surface 3.

In the technical solution of the embodiments of the present application, the first surface 2 and the transition surface 3 are both planar, and the angle α1 between the first surface 2 and the transition surface 3 satisfies 110° ≤ α1 ≤ 150°. When α1 ≥ 110°, it reduces the risk of stress concentration causing damage to the electrode tabs 102 due to an excessively small angle corresponding to the first edge 5 where the conductive block 1 abuts the electrode tabs 102, and also reduces the risk of creases generated during pressing causing the electrode tabs 102 to lift, thereby improving the reliability of the electrode assembly 100, and thus improving the reliability of battery cells 105 and batteries. When α1 ≤ 150°, it reduces the risk of stress concentration causing damage to the electrode tabs 102 due to an excessively small angle corresponding to the second edge 6 where the conductive block 1 abuts the electrode tabs 102, and also reduces the risk of creases generated during pressing causing the electrode tabs 102 to lift, thereby improving the reliability of the electrode assembly 100, and thus improving the reliability of battery cells 105 and batteries.

Referring to FIGs. 6 and 7, in some embodiments, the first surface 2 is planar, the transition surface 3 is an arcuate surface, and the transition surface 3 is tangent to the first surface 2.

In some embodiments, the first surface 2 may be planar, the transition surface 3 may be an arcuate surface, and the transition surface 3 may be tangent to the first surface 2. When the transition surface 3 is tangent to the first surface 2, a connection between the first surface 2 and the transition surface 3 is smoother, and the likelihood of an angular transition at the first edge 5 is reduced, thereby reducing a depth of creases corresponding to the first edge 5 during the pressing process.

In some embodiments, the first surface 2 may be planar, the transition surface 3 may be an arcuate surface, and the transition surface 3 may not be tangent to the first surface 2, that is, at a connection between the first surface 2 and the transition surface 3, similar to when both the first surface 2 and the transition surface 3 are planar, there is an angular transition at the first edge 5.

In the technical solution of the embodiments of the present application, when the first surface 2 is planar and the transition surface 3 is an arcuate surface, the transition surface 3 is tangent to the first surface 2, making the abutment of the first edge 5 with the electrode tabs 102 smoother when the conductive block 1 presses the electrode tabs 102, reducing the risk of damage to the electrode tabs 102 due to the first edge 5 of the conductive block 1 abutting the electrode tabs 102, and also reducing the risk of creases generated during pressing causing the electrode tabs 102 to lift, thereby improving the reliability of the electrode assembly 100, and thus improving the reliability of battery cells 105 and batteries.

Referring to FIGs. 4 to 9, in some embodiments, the conductive block 1 further includes a first surface 2 and a second surface 4, the first surface 2, the transition surface 3, and the second surface 4 are sequentially disposed along a circumferential direction of the conductive block 1, the first surface 2 intersects the transition surface 3 at a first edge 5, and the transition surface 3 intersects the second surface 4 at a second edge 6; where the first edge 5 and the second edge 6 define a first reference plane 7, and the transition surface 3 is an arcuate surface protruding from the first reference plane 7.

In some embodiments, an intersection of two surfaces is an edge, the first edge 5 is a connection between the transition surface 3 and the first surface 2, and the second edge 6 is a connection between the transition surface 3 and the second surface 4. It should be noted that an edge is not necessarily a corner edge between two surfaces. For example, referring to FIGs. 6 and 7, when the transition surface 3 is an arcuate surface and the transition surface 3 is connected to and tangent to the first surface 2, the likelihood of a corner is reduced, and the first edge 5 is merely the connection between the transition surface 3 and the first surface 2.

In some embodiments, the first surface 2, the transition surface 3, and the second surface 4 are circumferential surfaces of the conductive block 1 and may extend along the second direction Y. In the figures, the second direction may be represented by Y.

Referring to FIGs. 6 and 7, in some embodiments, the first surface 2 may be planar, and the transition surface 3 may be an arcuate surface. The first edge 5 is a connection between the transition surface 3 and the first surface 2, and the second edge 6 is a connection between the transition surface 3 and the second surface 4, that is, the first edge 5 and the second edge 6 are two ends of the transition surface 3, and the first edge 5 and the second edge 6 define the first reference plane 7, that is, both the first edge 5 and the second edge 6 are located on the first reference plane 7, and the first reference plane 7 is an imaginary virtual plane. An angle between the first reference plane 7 and the first surface 2 is an obtuse angle, and the transition surface 3 is an arcuate surface protruding from the first reference plane 7, that is, during the pressing process, when the first surface 2 is disposed along the horizontal direction, the transition surface 3 is an arcuate surface, with an overall extension trend inclined upward toward a direction approaching the main body 101 of the electrode assembly 100, such that both the first edge 5 and the second edge 6 abut the electrode tabs 102.

In some embodiments, the first surface 2 may be planar, and the transition surface 3 may be an arcuate surface. When the transition surface 3 is an arcuate surface, the transition surface 3 entirely or partially abuts the electrode tabs 102, distributing the pressure when the conductive block 1 presses the electrode tabs 102 over a larger contact area, reducing the risk of stress concentration causing damage to the electrode tabs 102 due to only one edge abutting the electrode tabs 102 during pressing, as well as the risk of stress concentration causing damage to the electrode tabs 102 due to an excessively small angle corresponding to the first edge 5 where the conductive block 1 abuts the electrode tabs 102, and also reducing the risk of creases generated during pressing causing the electrode tabs 102 to lift, thereby improving the reliability of the electrode assembly 100, and thus improving the reliability of battery cells 105 and batteries.

In some embodiments, an angle formed between the first reference plane 7 and the first surface 2 is an obtuse angle.

The technical solution of the embodiments of the present application conducts withstand voltage testing on the electrode assembly 100 through the conductive block 1, where the first surface 2 of the conductive block 1 presses the electrode tabs 102 of the electrode assembly 100, the first surface 2 is connected to the transition surface 3 via the first edge 5, and the second surface 4 is connected to the transition surface 3 via the second edge 6. When the transition surface 3 is planar, an included angle between the transition surface 3 and the first surface 2 is an obtuse angle; when the transition surface 3 is an arcuate surface, an included angle between the first reference plane 7 defined by the first edge 5 and the second edge 6 and the first surface 2 is an obtuse angle. When the first surface 2 presses the electrode tabs 102, both the first edge 5 and the second edge 6 can abut the electrode tabs 102, and the included angle between the first reference plane 7 and the first surface 2 being an obtuse angle reduces the risk of stress concentration causing damage to the electrode tabs 102 due to only one edge abutting the electrode tabs 102 during pressing by the conductive block 1, as well as the risk of stress concentration causing damage to the electrode tabs 102 due to an excessively small angle corresponding to the first edge 5 where the conductive block 1 abuts the electrode tabs 102, and also reduces the risk of creases generated during pressing causing the electrode tabs 102 to lift, thereby improving the reliability of the electrode assembly 100, and thus improving the reliability of battery cells 105 and batteries.

Referring to FIGs. 6 and 7, in some embodiments, an angle between the first reference plane 7 and the first surface 2 is α2, satisfying: 110° ≤ α2 ≤ 150°.

In some embodiments, the first surface 2 may be planar, the transition surface 3 may be an arcuate surface, the first edge 5 and the second edge 6 of the transition surface 3 define the first reference plane 7, and an angle between the first surface 2 and the first reference plane 7 is α1. During the pressing process, both the first surface 2 and the first reference plane 7 extend along the second direction Y, and the first surface 2 is disposed along the horizontal direction. Taking the extension direction of the first surface 2 and the second reference plane 8 as the observation direction, where the perspective direction of FIG. 7 is the same as this observation direction. In this observation direction, the first surface 2 and the first reference plane 7 are two connected straight lines, and an included angle between the two straight lines is α2.

In some embodiments, α2 satisfies 110° ≤ α2 ≤ 150°. For example, α2 may be 110°, 112°, 114°, 116°, 118°, 120°, 122°, 124°, 126°, 128°, 130°, 132°, 134°, 136°, 138°, 140°, 142°, 144°, 146°, 148°, or 150°.

In some embodiments, α2 may be 135°.

In some embodiments, the method of measuring the angle α2 may involve attaching a protractor to a surface connected to both the first surface 2 and the transition surface 3, and drawing a straight line connecting the first edge 5 and the second edge 6 on this surface to measure the included angle between the first surface 2 and this straight line, where the measured included angle is the included angle α2 between the first surface 2 and the first reference plane 7.

In the technical solution of the embodiments of the present application, the first surface 2 is planar, the transition surface 3 is an arcuate surface, and the angle α2 between the first surface 2 and the first reference plane 7 satisfies 110° ≤ α2 ≤ 150°. When α2 ≥ 110°, it reduces the risk of stress concentration causing damage to the electrode tabs 102 due to an excessively small angle corresponding to the first edge 5 where the conductive block 1 abuts the electrode tabs 102, and also reduces the risk of creases generated during pressing causing the electrode tabs 102 to lift, thereby improving the reliability of the electrode assembly 100, and thus improving the reliability of battery cells 105 and batteries. When α2 ≤ 150°, it reduces the risk of stress concentration causing damage to the electrode tabs 102 due to an excessively small angle corresponding to the second edge 6 where the conductive block 1 abuts the electrode tabs 102, and also reduces the risk of creases generated during pressing causing the electrode tabs 102 to lift, thereby improving the reliability of the electrode assembly 100, and thus improving the reliability of battery cells 105 and batteries.

Referring to FIG. 8, in some embodiments, both the first surface 2 and the second surface 4 may be planar. The transition surface 3 includes a plurality of sub-surfaces 19, the plurality of sub-surfaces 19 define the transition surface 3, the first edge 5 and the second edge 6 define the first reference plane 7, an included angle between the first surface 2 and the first reference plane 7 may be an obtuse angle, and an included angle between the second surface 4 and the first reference plane 7 may be an obtuse angle. The plurality of sub-surfaces 19 are all planar, an included angle between a sub-surface 19 closest to the first surface 2 and the first surface 2 is an obtuse angle, an included angle between a sub-surface 19 closest to the second surface 4 and the second surface 4 is an obtuse angle, and an included angle between any two adjacent sub-surfaces 19 is an obtuse angle. Each connection between two adjacent sub-surfaces 19 may abut the electrode tabs 102.

Referring to FIGs. 6 and 7, in some embodiments, the second surface 4 is planar, the transition surface 3 is an arcuate surface, and the transition surface 3 is tangent to the second surface 4.

In some embodiments, the second surface 4 may be planar, the transition surface 3 may be an arcuate surface, and the transition surface 3 may be tangent to the second surface 4. When the transition surface 3 is tangent to the second surface 4, a connection between the second surface 4 and the transition surface 3 is smoother, and the likelihood of an angular transition at the second edge 6 is reduced, thereby reducing a depth of creases corresponding to the second edge 6 during the pressing process.

In some embodiments, the second surface 4 may be planar, the transition surface 3 may be an arcuate surface, and the transition surface 3 may not be tangent to the second surface 4, that is, at a connection between the second surface 4 and the transition surface 3, similar to when both the second surface 4 and the transition surface 3 are planar, there is an angular transition at the second edge 6.

In the technical solution of the embodiments of the present application, when the second surface 4 is planar and the transition surface 3 is an arcuate surface, the transition surface 3 is tangent to the second surface 4, making the abutment of the second edge 6 with the electrode tabs 102 smoother when the conductive block 1 presses the electrode tabs 102, reducing the risk of damage to the electrode tabs 102 due to the second edge 6 of the conductive block 1 abutting the electrode tabs 102, and also reducing the risk of creases generated during pressing causing the electrode tabs 102 to lift, thereby improving the reliability of the electrode assembly 100, and thus improving the reliability of battery cells 105 and batteries.

In some embodiments, an extension plane of the first surface 2 intersects an extension plane of the second surface 4.

Referring to FIG. 7, in some embodiments, the extension plane of the first surface 2 may intersect the extension plane of the second surface 4. The extension plane of the first surface 2 is an extension of the first surface 2 from the first edge 5; the extension plane of the second surface 4 is an extension of the second surface 4 from the second edge 6. The two extension planes intersect, that is, when the first surface 2 and the transition surface 3 extend along the second direction Y, the first surface 2 and the second surface 4 are not parallel, and the extension plane of the first surface 2 and the extension plane of the transition surface 3 intersect at a first reference line 18, where the first reference line 18 is an imaginary virtual line.

During the pressing process, taking the extension direction of the first surface 2 and the second surface 4 as the observation direction, where the perspective direction of FIG. 7 is the same as this observation direction. In this observation direction, the extension plane of the first surface 2 and the extension plane of the second surface 4 are two intersecting straight lines.

Referring to FIG. 9, in some embodiments, the extension plane of the first surface 2 may not intersect the extension plane of the second surface 4, and at this time, the first surface 2 and the second surface 4 are parallel to each other.

Referring to FIG. 7, in some embodiments, the extension plane of the first surface 2 is orthogonal to the extension plane of the second surface 4.

Referring to FIG. 7, in some embodiments, the extension plane of the first surface 2 may be orthogonal to the extension plane of the second surface 4, that is, during the pressing process, the first surface 2 is disposed along the horizontal direction, and the second surface 4 is disposed along the vertical direction. Taking the extension direction of the first surface 2 and the second surface 4 as the observation direction, where the perspective direction of FIG. 7 is the same as this observation direction, in this observation direction, the extension plane of the first surface 2 and the extension plane of the second surface 4 are two mutually perpendicular straight lines.

Referring to FIGs. 6 and 7, in some embodiments, the first surface 2 is planar, the transition surface 3 is an arcuate surface, a second reference plane 8 is parallel to the first reference plane 7, and the second reference plane 8 is tangent to the transition surface 3, a distance between the first reference plane 7 and the second reference plane 8 is d1, the extension plane of the first surface 2 intersects the extension plane of the second surface 4 at a first reference line 18, the first reference line 18 is parallel to the first reference plane 7, and a distance between the first reference line 18 and the first reference plane 7 is d2, satisfying: 0.3d2 ≤ d1 ≤ 0.7d2.

In some embodiments, the first surface 2 may be planar, and the transition surface 3 may be an arcuate surface. There exists a second reference plane 8 tangent to the transition surface 3, and the second reference plane 8 is parallel to the first reference plane 7. Both the first reference plane 7 and the second reference plane 8 are imaginary virtual planes. A distance between the first reference plane 7 and the second reference plane 8 is d1. The first surface 2 and the transition surface 3 extend along the second direction Y, forming the first reference line 18 parallel to the first reference plane 7, and a distance between the first reference line 18 and the first reference plane 7 is d2, satisfying: 0.3d2 ≤ d1 ≤ 0.7d2.

In some embodiments, the method of measuring d1 and d2 may involve, on a surface connected to both the first surface 2 and the transition surface 3, drawing a straight line connecting the first edge 5 and the second edge 6, taking a flat plate tangent to the transition surface 3 and parallel to this straight line, and measuring a distance between this flat plate and the straight line, which is the value of d1. Then, take two flat plates respectively attached to the first surface 2 and the second surface 4, where the two flat plates intersect, and measure a distance from the flat plate tangent to the transition surface 3 to the intersection position of the two flat plates, which is the value of d2.

In the technical solution of the embodiments of the present application, the first surface 2 is planar, the transition surface 3 is an arcuate surface, a distance between the first reference plane 7 and the second reference plane 8 is d1, and a distance between the first reference line 18 and the first reference plane 7 is d2, satisfying 0.3d2 ≤ d1 ≤ 0.7d2. When d1 ≥ 0.3d2, it can increase a contact area between the transition surface 3 and the electrode tabs 102, reducing the risk of damage to the electrode tabs 102 due to the second edge 6 of the conductive block 1 abutting the electrode tabs 102, and also reducing the risk of creases generated during pressing causing the electrode tabs 102 to lift, thereby improving the reliability of the electrode assembly 100, and thus improving the reliability of battery cells 105 and batteries. When d1 ≤ 0.7d2, it can reduce the risk of damage to the electrode tabs 102 due to excessive protrusion of the transition surface 3 beyond the first reference plane 7, and also reduce the risk of stress concentration causing damage to the electrode tabs 102 due to the second edge 6 not abutting the electrode tabs 102, leading to the first edge 5 abutting the electrode tabs 102.

Referring to FIGs. 4 to 7, in some embodiments, the conductive block 1 includes a third surface 9 connected to the second surface 4, the third surface 9 is parallel to the first surface 2, and a distance between the first surface 2 and the third surface 9 is d3, satisfying: 0 < d3 ≤ 50 mm.

In some embodiments, the conductive block 1 includes a third surface 9, the third surface 9 is connected to the second surface 4, and the third surface 9 is parallel to the first surface 2. During the process of pressing the electrode tabs 102, the first surface 2 may be disposed along the horizontal direction, the second surface 4 may be disposed along the vertical direction, the third surface 9 may be disposed along the horizontal direction, and a distance between the first surface 2 and the third surface 9 is d3, that is, a height of the conductive block 1 when pressing the electrode tabs 102.

In some embodiments, during the process of pressing the electrode tabs 102, the first surface 2 may be disposed along the horizontal direction, the third surface 9 may be disposed along the horizontal direction, and the second surface 4 may be disposed inclined upward in a direction away from the main body 101 of the electrode assembly 100.

In some embodiments, a distance between the first surface 2 and the third surface 9 is d3, satisfying: 0 < d3 ≤ 50 mm. For example, d3 may be 5 mm, 10 mm, 15 mm, 20 mm, 25 mm, 30 mm, 35 mm, 40 mm, 45 mm, or 50 mm.

In some embodiments, the method of measuring a distance d3 between the first surface 2 and the third surface 9 may involve using a caliper to clamp both the first surface 2 and the third surface 9, where the measured vertical distance is the distance d3 between the first surface 2 and the third surface 9.

In the technical solution of the embodiments of the present application, the third surface 9 is connected to the second surface 4 and the third surface 9 is parallel to the second surface 4, and a distance d3 between the first surface 2 and the third surface 9 satisfies 0 < d3 ≤ 50 mm. During withstand voltage testing of the electrode assembly 100, after clamping both ends of the main body 101 of the electrode assembly 100 with pressing plates, the conductive block 1 presses the electrode tabs 102, and when d3 ≤ 50 mm, the risk of interference between the conductive block 1 and the pressing plates due to an excessively large size of the conductive block 1 can be reduced, thereby improving the convenience of pressing the electrode tabs 102 with the conductive block 1.

In some embodiments, 10 mm ≤ d3 ≤ 20 mm.

In some embodiments, a distance between the first surface 2 and the third surface 9 is d3, satisfying: 10 mm ≤ d3 ≤ 20 mm. For example, d3 may be 10 mm, 11 mm, 12 mm, 13 mm, 14 mm, 15 mm, 16 mm, 17 mm, 18 mm, 19 mm, or 20 mm.

In the technical solution of the embodiments of the present application, a distance d3 between the first surface 2 and the third surface 9 satisfies 10 mm ≤ d3 ≤ 20 mm. When d3 ≥ 10 mm, the conductive block 1 has a certain thickness, facilitating the pressing of the electrode tabs 102 and improving operational convenience. When d3 ≤ 20 mm, the risk of interference between the conductive block 1 and the pressing plates due to an excessively large size of the conductive block 1 can be better reduced, thereby improving the convenience of pressing the electrode tabs 102 with the conductive block 1.

Referring to FIG. 9, in some embodiments, the first surface 2 is parallel to the second surface 4, and a distance between the first surface 2 and the second surface 4 is d4, satisfying: 0 < d4 ≤ 50 mm.

In some embodiments, the second surface 4 is connected to the transition surface 3, and the second surface 4 is parallel to the first surface 2. During the process of pressing the electrode tabs 102, the first surface 2 may be disposed along the horizontal direction, the second surface 4 may also be disposed along the horizontal direction, and a distance between the first surface 2 and the second surface 4 is d4, that is, a height of the conductive block 1 when pressing the electrode tabs 102.

In some embodiments, a distance between the first surface 2 and the second surface 4 is d4, satisfying: 0 < d4 ≤ 50 mm. For example, d4 may be 5 mm, 10 mm, 15 mm, 20 mm, 25 mm, 30 mm, 35 mm, 40 mm, 45 mm, or 50 mm.

In some embodiments, the method of measuring a distance d4 between the first surface 2 and the second surface 4 may involve using a caliper to clamp both the first surface 2 and the second surface 4, where the measured vertical distance is the distance d4 between the first surface 2 and the third surface 9.

In the technical solution of the embodiments of the present application, the first surface 2 is parallel to the second surface 4, and a distance d4 between the first surface 2 and the second surface 4 satisfies 0 < d4 ≤ 50 mm. During withstand voltage testing of the electrode assembly 100, after clamping both ends of the main body 101 of the electrode assembly 100 with pressing plates, the conductive block 1 presses the electrode tabs 102, and when d4 ≤ 50 mm, the risk of interference between the conductive block 1 and the pressing plates due to an excessively large size of the conductive block 1 can be reduced, thereby improving the convenience of pressing the electrode tabs 102 with the conductive block 1.

In some embodiments, 10 mm ≤ d4 ≤ 20 mm.

In some embodiments, a distance between the first surface 2 and the second surface 4 is d4, satisfying: 10 mm ≤ d4 ≤ 20 mm. For example, d4 may be 10 mm, 11 mm, 12 mm, 13 mm, 14 mm, 15 mm, 16 mm, 17 mm, 18 mm, 19 mm, or 20 mm.

In the technical solution of the embodiments of the present application, a distance d4 between the first surface 2 and the second surface 4 satisfies 10 mm ≤ d4 ≤ 20 mm. When d4 ≥ 10 mm, the conductive block 1 has a certain thickness, facilitating the pressing of the electrode tabs 102 and improving operational convenience. When d4 ≤ 20 mm, the risk of interference between the conductive block 1 and the pressing plates due to an excessively large size of the conductive block 1 can be better reduced, thereby improving the convenience of pressing the electrode tabs 102 with the conductive block 1.

Referring to FIGs. 4 and 5, in some embodiments, the first surface 2, the transition surface 3, and the second surface 4 may all be planar. An included angle between the first surface 2 and the transition surface 3 may be an obtuse angle. During the pressing process, the first surface 2 may be disposed along the horizontal direction, the transition surface 3 may be disposed inclined upward toward a direction approaching the main body 101 of the electrode assembly 100, and the second surface 4 may be disposed along the vertical direction. The conductive block 1 further includes a third surface 9, a fourth surface 16, and two oppositely disposed fifth surfaces 17, where one end of the third surface 9 is connected to the second surface 4, and the third surface 9 may be parallel to the first surface 2. One end of the fourth surface 16 is connected to an end of the third surface 9 away from the third surface, the fourth surface 16 may be disposed along the vertical direction, the fourth surface 16 is parallel to the second surface 4, and another end of the fourth surface 16 is connected to an end of the first surface 2 away from the transition surface 3. The first surface 2, the transition surface 3, the second surface 4, the third surface 9, and the fourth surface 16 all extend along the second direction Y, and in this extension direction, the first surface 2, the transition surface 3, the second surface 4, the third surface 9, and the fourth surface 16 are enclosed by the two oppositely disposed fifth surfaces 17.

Referring to FIGs. 6 and 7, in some embodiments, the first surface 2 and the second surface 4 may both be planar, and the transition surface 3 may be an arcuate surface. The first edge 5 and the second edge 6 of the transition surface 3 define a first reference plane 7, and an included angle between the first surface 2 and the first reference plane 7 may be an obtuse angle. During the pressing process, the first surface 2 may be disposed along the horizontal direction, the transition surface 3 may protrude from the first reference plane 7, exhibiting a trend of inclining upward toward a direction approaching the main body 101 of the electrode assembly 100, and the second surface 4 may be disposed along the vertical direction. The conductive block 1 further includes a third surface 9, a fourth surface 16, and two fifth surfaces 17, where one end of the third surface 9 is connected to the second surface 4, and the third surface 9 may be parallel to the first surface 2. One end of the fourth surface 16 is connected to an end of the third surface 9 away from the third surface, the fourth surface 16 may be disposed along the vertical direction, the fourth surface 16 is parallel to the second surface 4, and another end of the fourth surface 16 is connected to an end of the first surface 2 away from the transition surface 3. The first surface 2, the transition surface 3, the second surface 4, the third surface 9, and the fourth surface 16 all extend along the second direction Y, and in this extension direction, the first surface 2, the transition surface 3, the second surface 4, the third surface 9, and the fourth surface 16 are enclosed by the two fifth surfaces 17, where the two fifth surfaces 17 are parallel.

The technical solution of the embodiments of the present application conducts withstand voltage testing on the electrode assembly 100 through the conductive block 1. When the first surface 2 presses the electrode tabs 102, both the first edge 5 and the second edge 6 can abut the electrode tabs 102, and an included angle between the first surface 2 and the transition surface 3 is an obtuse angle, or an included angle between the first reference plane 7 and the first surface 2 is an obtuse angle, reducing the risk of stress concentration causing damage to the electrode tabs 102 during pressing by the conductive block 1, and also reducing the risk of creases generated during pressing causing the electrode tabs 102 to lift, thereby improving the reliability of the electrode assembly 100, and thus improving the reliability of battery cells 105 and batteries.

In some embodiments, the conductive block 1 may be processed by integral molding.

In some embodiments, the conductive block 1 may be made of a metal material, for example, copper, iron, nickel, or the like.

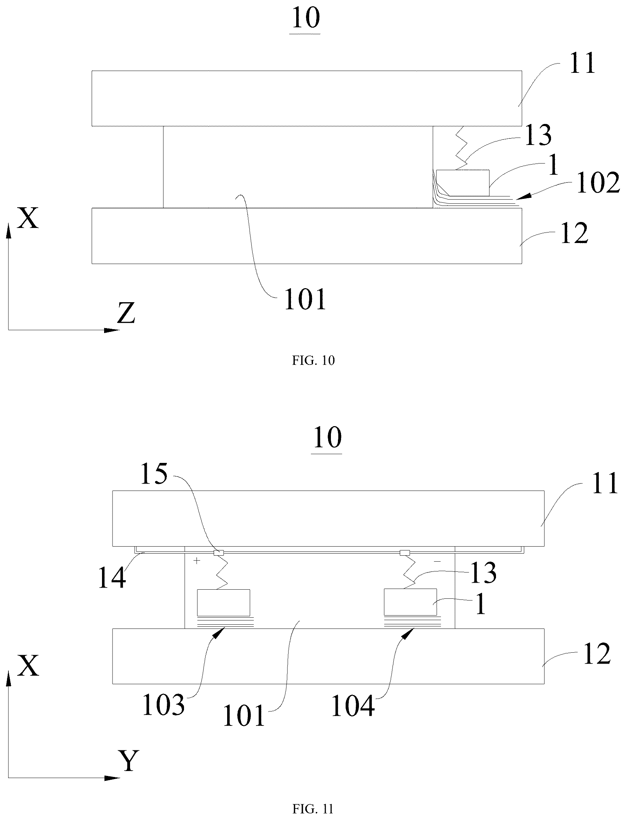

Referring to FIGs. 10 to 11, FIG. 10 is a schematic structural diagram of a detection mechanism 10 provided by some embodiments of the present application, and FIG. 11 is a schematic diagram of the detection mechanism 10 in FIG. 10 from another perspective. It should be noted that the another perspective in FIG. 11 is a viewpoint along the third direction Z, where the third direction may be represented by Z, the third direction Z may be perpendicular to the second direction Y, and the third direction Z may be a direction perpendicular to the fourth surface 16. Embodiments of the present application further provide a detection mechanism 10 configured for withstand voltage testing of an electrode assembly 100, where the detection mechanism 10 includes the conductive block 1 according to any one of the embodiments of the first aspect, a first pressing plate 11, a second pressing plate 12, and an elastic member 13, the conductive block 1 is used for pressing electrode tabs 102 of the electrode assembly 100, the first pressing plate 11 and the second pressing plate 12 are spaced apart along a first direction X, the first pressing plate 11 and the second pressing plate 12 are used for clamping a main body 101 of the electrode assembly 100; one end of the elastic member 13 is connected to the first pressing plate 11, and another end of the elastic member 13 is connected to the conductive block 1.

In some embodiments, when pressing the electrode tabs 102, the first pressing plate 11 and the second pressing plate 12 may be spaced apart along the first direction X, and the conductive block 1 is connected to the first pressing plate 11 via the elastic member 13. One end of the main body 101 of the electrode assembly 100 is disposed on the second pressing plate 12, the first pressing plate 11 abuts another end of the main body 101 in the first direction X, and the first pressing plate 11 and the second pressing plate 12 together clamp the main body 101. The electrode tabs 102 are disposed along the horizontal direction, the electrode tabs 102 may be multi-layer electrode tabs 102, and the conductive block 1 presses a portion of the electrode tabs 102 close to the first pressing plate 11 in the first direction X.

In the figures, the direction indicated by the letter X may be the first direction X. In some embodiments, the first direction X may be the vertical direction.

In some embodiments, during withstand voltage testing of the electrode assembly 100, the first pressing plate 11 and the second pressing plate 12 respectively clamp two end surfaces of the main body 101 of the electrode assembly 100 in the first direction X, and the conductive block 1 moves toward the second pressing plate 12 along the first direction X through deformation of the elastic member 13 until pressing of the electrode tabs 102 is completed. At this time, by externally connecting a conductive wire, the conductive block 1 is connected to an external short-circuit control mechanism to achieve energization and withstand voltage testing of the electrode assembly 100.

In some embodiments, the principle of the external short-circuit control mechanism may be that, after the short-circuit control mechanism sends a high-voltage signal to the electrode assembly 100 to be tested, if a voltage-holding segment of a test curve of the electrode assembly 100 is inconsistent with a standard curve, it is determined that the electrode assembly 100 may be a micro-short-circuit electrode assembly 100.

In some embodiments, the elastic member 13 may be a spring.

In some embodiments, the connection between the elastic member 13 and the first pressing plate 11 may be by welding or bonding. The connection between the elastic member 13 and the conductive block 1 may be by welding or bonding.

In the technical solution of the embodiments of the present application, the detection mechanism 10 conducts withstand voltage testing on the electrode assembly 100, the detection mechanism 10 includes the first pressing plate 11, the second pressing plate 12, the conductive block 1, and the elastic member 13, the first pressing plate and the second pressing plate together clamp the main body 101 of the electrode assembly 100, the conductive block 1 is connected to the first pressing plate via the elastic member 13, and the conductive block 1 presses the electrode tabs 102 of the electrode assembly 100. The detection mechanism 10 conducts withstand voltage testing on the electrode assembly 100, reducing the risk of damage to the electrode tabs 102, as well as the risk of creases generated during pressing causing the electrode tabs 102 to lift, thereby improving the reliability of the electrode assembly 100, and thus improving the reliability of battery cells 105 and batteries.

Referring to FIG. 11, in some embodiments, the conductive block 1 is configured as two, where the two conductive blocks 1 are respectively used for pressing a positive electrode tab 103 and a negative electrode tab 104 of the electrode assembly 100.

In some embodiments, the number of conductive blocks 1 may be two, respectively pressing the positive electrode tab 103 and the negative electrode tab 104. The embodiments of the present application take the positive electrode tab 103 and the negative electrode tab 104 being located at the same end of the main body 101 as an example.

In the technical solution of the embodiments of the present application, the two conductive blocks 1 respectively press the positive electrode tab 103 and the negative electrode tab 104, where simultaneously pressing the positive electrode tab 103 and the negative electrode tab 104 improves detection efficiency and convenience.

Referring to FIG. 11, in some embodiments, a distance between the two conductive blocks 1 is adjustable to adapt to electrode assemblies 100 of different sizes.

In some embodiments, different electrode assemblies 100 have different sizes of the main body 101 in the horizontal direction, so the distance between the two conductive blocks 1 needs to be adjusted to improve operational convenience.

In the technical solution of the embodiments of the present application, the two conductive blocks 1 respectively press the positive electrode tab 103 and the negative electrode tab 104. For electrode assemblies 100 of different sizes, the distance between the positive electrode tab 103 and the negative electrode tab 104 varies. By adjusting the distance between the two conductive blocks 1, it adapts to electrode assemblies 100 of different sizes to press positive electrode tabs 103 and negative electrode tabs 104 at different distances, thereby improving the practicality and applicability of the detection mechanism 10.

Referring to FIG. 11, in some embodiments, the first pressing plate 11 is provided with a slide rod 14 and a slide block 15, the slide block 15 is slidably disposed on the slide rod 14, one end of the elastic member 13 is connected to the slide block 15, and another end of the elastic member 13 is connected to the conductive block 1.

In some embodiments, the first pressing plate 11 is provided with a slide rod 14, and when pressing the electrode tabs 102, the slide rod 14 may be disposed along the horizontal direction, and the connection between the slide rod 14 and the first pressing plate 11 may be by welding. The slide block 15 is disposed on the slide rod 14, the slide rod 14 can be regarded as a slideway extending along the horizontal direction, the slide block 15 can move relative to the slide rod 14 on the slide rod 14, one end of the elastic member 13 is connected to the slide block 15, and another end of the elastic member 13 is connected to the conductive block 1, that is, by moving the slide block 15, the conductive block 1 can be moved in the horizontal direction.

In some embodiments, a latch may be provided between the slide block 15 and the slide rod 14. When it is necessary to fix the slide block 15 on the slide rod 14 to fix the position of the conductive block 1 in the horizontal direction, the slide block 15 is locked to the slide rod 14 by the latch; when it is necessary to move the slide block 15 on the slide rod 14 to change the position of the conductive block 1 in the horizontal direction, the latch is released to allow the slide block 15 to move relative to the slide rod 14 on the slide rod 14.

In the technical solution of the embodiments of the present application, by providing the slide rod 14 on the first pressing plate 11 and connecting the conductive block 1 to the slide block 15 via the elastic member 13, the slide block 15 can slide on the slide rod 14 to achieve adjustment of the distance between the two conductive blocks 1, improving the applicability and practicality of the detection mechanism 10. Additionally, the slide rod 14 and slide block 15 structure is simple, easy to obtain, and cost-effective.

Although the present application has been described with reference to preferred embodiments, various improvements can be made thereto and components therein can be replaced with equivalents without departing from the scope of the present application. In particular, as long as there is no structural conflict, the various technical features mentioned in the embodiments can be combined in any manner. The present application is not limited to the specific embodiments disclosed in this specification but includes all technical solutions falling within the scope of the claims.

## Claims

1. A conductive block for pressing electrode tabs of an electrode assembly for withstand voltage testing, wherein the conductive block comprises a transition surface, and the transition surface matches an inclined surface formed after the electrode tabs are pressed.

2. The conductive block according to claim 1, wherein the conductive block further comprises a first surface, the first surface is used for pressing the electrode tabs, and the transition surface is disposed adjacent to the first surface.

3. The conductive block according to claim 2, wherein the first surface and the transition surface are both planar, and an angle formed between the first surface and the transition surface is an obtuse angle.

4. The conductive block according to claim 3, wherein the angle between the first surface and the transition surface is α1, satisfying: 110° ≤ α1 ≤ 150°.

5. The conductive block according to claim 2, wherein the first surface is planar, and the transition surface is an arcuate surface.

6. The conductive block according to claim 5, wherein the transition surface is tangent to the first surface.

7. The conductive block according to any one of claims 5 and 6, wherein the conductive block further comprises a second surface, the first surface, the transition surface, and the second surface are sequentially disposed along a circumferential direction of the conductive block, the first surface intersects the transition surface at a first edge, and the transition surface connects to and intersects the second surface at a second edge; wherein
the first edge and the second edge define a first reference plane, and the transition surface is an arcuate surface protruding from the first reference plane.

8. The conductive block according to claim 7, wherein an angle formed between the first reference plane and the first surface is an obtuse angle.

9. The conductive block according to any one of claims 7 and 8, wherein an angle between the first reference plane and the first surface is α2, satisfying: 110° ≤ α2 ≤ 150°.

10. The conductive block according to any one of claims 7 to 9, wherein the transition surface is tangent to the second surface.

11. The conductive block according to any one of claims 7 to 10, wherein an extension plane of the first surface intersects an extension plane of the second surface.

12. The conductive block according to any one of claims 7 to 11, wherein the extension plane of the first surface is orthogonal to the extension plane of the second surface.

13. The conductive block according to any one of claims 7 to 12, wherein a second reference plane is parallel to the first reference plane, and the second reference plane is tangent to the transition surface, a distance between the first reference plane and the second reference plane is d1, the extension plane of the first surface intersects the extension plane of the second surface at a first reference line, the first reference line is parallel to the first reference plane, and a distance between the first reference line and the first reference plane is d2, satisfying: 0.3d2 ≤ d1 ≤ 0.7d2.

14. The conductive block according to any one of claims 1 to 13, wherein the conductive block comprises a third surface connected to the second surface, the third surface is parallel to the first surface, and a distance between the first surface and the third surface is d3, satisfying: 0 < d3 ≤ 50 mm.

15. The conductive block according to claim 14, wherein 10 mm ≤ d3 ≤ 20 mm.

16. The conductive block according to any one of claims 1 to 15, wherein the first surface is parallel to the second surface, and a distance between the first surface and the second surface is d4, satisfying: 0 < d4 ≤ 50 mm.

17. The conductive block according to claim 16, wherein 10 mm ≤ d4 ≤ 20 mm.

18. A detection mechanism for withstand voltage testing of an electrode assembly, comprising:
a conductive block according to any one of claims 1 to 17, used for pressing electrode tabs of the electrode assembly;
a first pressing plate and a second pressing plate, wherein the first pressing plate and the second pressing plate are spaced apart along a first direction, and the first pressing plate and the second pressing plate are used for clamping a main body of the electrode assembly; and
an elastic member, wherein one end of the elastic member is connected to the first pressing plate, and another end of the elastic member is connected to the conductive block.

19. The detection mechanism according to claim 18, wherein the conductive block is configured as two, and the two conductive blocks are respectively used for pressing a positive electrode tab and a negative electrode tab of the electrode assembly.

20. The detection mechanism according to claim 19, wherein a distance between the two conductive blocks is adjustable to adapt to electrode assemblies of different sizes.

21. The detection mechanism according to claim 20, wherein the first pressing plate is provided with a slide rod and a slide block, the slide block is slidably disposed on the slide rod, one end of the elastic member is connected to the slide block, and another end of the elastic member is connected to the conductive block.
